## Europäisches Patentamt

## European Patent Office

## Office européen des brevets

(11) Veröffentlichungsnummer: **0 373 528**
**A2**

(12) **EUROPÄISCHE PATENTANMELDUNG**

(21) Anmeldenummer: 89122670.6

(51) Int. Cl.5: **H05K 3/22, H01H 37/74**

(22) Anmeldetag: 08.12.89

(30) Priorität: **14.12.88 CH 4614/88**

(43) Veröffentlichungstag der Anmeldung:
**20.06.90 Patentblatt 90/25**

(84) Benannte Vertragsstaaten:
**AT CH DE FR GB IT LI NL SE**

(71) Anmelder: **SIEMENS-ALBIS
AKTIENGESELLSCHAFT
PV/Patente und Verträge Postfach
CH-8047 Zürich(CH)**

(84) **CH LI**

Anmelder: **Siemens Aktiengesellschaft
Wittelsbacherplatz 2
D-8000 München 2(DE)**

(84) **DE FR GB IT NL SE AT**

(72) Erfinder: **Willi, Walter
Postfach 618
CH-8026 Zürich(CH)**

(54) **Verfahren zum wahlweisen Herstellen von Thermosicherungen, elektrischen Verbindungen oder Unterbrüchen.**

(57) Zum wahlweisen Herstellen von Thermosicherungen, elektrischen Verbindungen oder Unterbrüchen wird auf einem Substrat (5) zwischen zwei Anschlüssen (3,4 ) eine Schicht (1) und darüber eine Schicht (2) aufgetragen, wobei mindestens eine der beiden Schichten (1,2) zwischen den Anschlüssen (3,4) eine elektrisch leitende Verbindung bildet. Dabei wird vorgesehen, dass die Schicht (1) bzw.(2) , im Vergleich zu den Anschlüssen (3,4), gegenüber der Schicht (2) bzw. (1) eine deutlich geringere Ablegierfestigkeit besitzt.

Nach einer Erwärmung des Substrats (5) bzw. der Schichten (1,2) auf eine bestimmte Temperatur wird die schicht (1) bzw. (2) durch die Schicht (2) bzw. (1) ablegiert, wobei die Schicht (1) vom Substrat (5) abgelöst wird. Die verbleibende Schicht wird nachfolgend im flüssigen Zustand durch die Oberflächenspannung in zwei Teile geteilt, welche sich in der Folge auf die beiden Anschlüsse (3,4) zurückziehen. Die Verbindung wird somit beim Überschreiten einer bestimmten Temperatur gelöst.

Fig. 1

# Verfahren zum wahlweisen Herstellen von Thermosicherungen, elektrischen Verbindungen oder Unterbrüchen

Die vorliegende Erfindung betrifft ein Verfahren zum wahlweisen Herstellen von Thermosicherungen, elektrischen Verbindungen oder Unterbrüchen gemäss dem Oberbegriff des Hauptanspruchs.

Zur thermischen Absicherung von elektrischen Schaltungen werden normalerweise temperaturempfindliche Elemente eingebaut, die eine elektrische Verbindung beim Auftreten eines Störfalles bzw. einer Übertemperatur unterbrechen. Zu diesem Zweck werden zwei elektrische Anschlüsse, die sich auf einem Substrat befinden, oft durch einen Draht aus einem Material verbunden, das einen tiefen Schmelzpunkt aufweist. Bei entsprechendem Ansteigen der Temperatur des Substrats schmilzt der Draht und die Verbindung zwischen den beiden Anschlüssen wird unterbrochen. Nachteilig bei diesem Verfahren ist, dass für das Einlöten des Schmelzdrahtes zusätzliche Arbeitsgänge und Arbeitsmittel notwendig sind. Dies ist speziell unvorteilhaft, falls mehrere Thermosicherungen auf ein Substrat aufgebracht werden sollen. Der Einbau von Sicherungen nach dem bekannten Verfahren erfordert daher einen hohen Zeit- und Kostenaufwand. Ferner lassen sich spezielle Eigenschaften der Thermosicherung (z.B. Auslösegeschwindigkeit oder Auslösetemperatur) nur mit zusätzlichem Aufwand und Kosten realisieren. So müssten z.B. spezielle Lötdrähte angefertigt werden, die unter genauer Dosierung des verwendeten Lotes aufgetragen werden.

Weiterhin ist es oft notwendig, auf einer bestehenden Schaltung, entsprechend den Anforderungen des Anwenders, elektrische Verbindungen oder Thermosicherungen aufzubringen oder Unterbrüche zu erzeugen. Die dafür allgemein bekannten Verfahren (Einlöten von Verbindungs - bzw. Sicherungsdrähten; Auftrennen von Verbindungen z.B. mittels Laser) haben wiederum den Nachteil, dass sie verschiedene Arbeitsgänge und Arbeitsmittel erfordern, was mit einem hohen Zeit- und Kostenaufwand verbunden ist.

Der vorliegenden Erfindung liegt daher die Aufgabe zugrunde, die bekannten Verfahren zu verbessern. Diese Aufgabe wird durch die im kennzeichnenden Teil des Hauptanspruchs angegebenen Massnahmen gelöst. Vorteilhafte Weiterbildungen der Erfindung sind in weiteren Ansprüchen angegeben.

Die wichtigsten Vorteile des erfindungsgemässen Verfahrens sind :
Thermosicherungen, elektrische Verbindungen und Unterbrüche können in ein bzw. zwei Verfahrensschritten auf ein Substrat aufgetragen werden. Dies ist speziell von Vorteil, falls eine vorgefertigte Schaltung, auf der sich mehrere Kontaktstellen befinden, nachträglich entsprechend den Anforderungen des Anwenders modifiziert bzw. programmiert werden soll. Das heisst, z.B. kann ein Unterbruch oder eine Verbindung im zweiten Verfahrensschritt in eine Thermosicherung umgewandelt werden. Die Thermosicherungen können nach dem erfindungsgemässen Verfahren mit genau definierten Eigenschaften (Auslösegeschwindigkeit, Auslösetemperaturbereich etc.) in hoher Qualität hergestellt werden. Das Auslösen der Thermosicherung erfolgt ohne Abspringen von Metallteilen, welche in weiteren Schaltungsteilen Störungen verursachen könnten. Weitere signifikante Vorteile weisen die erfindungsgemässen Weiterbildungen auf. So kann z.B. kostengünstig ein präziser Temperaturindikator erzeugt werden, der anzeigt, ob beim Betrieb der Schaltung eine bestimmte Temperatur, z.B. die maximale Betriebstemperatur, überschritten wurde. Weiterhin kann eine Thermosicherung hergestellt werden, die beim Überschreiten einer vorgegebenen Temperatur eine elektrische Verbindung auflöst und/oder eine mechanische Öffnung freigibt, aus der z.B. ein Schutzgas austreten kann.

Die Erfindung wird nachfolgend anhand von Zeichnungen beispielsweise näher erläutert. Dabei zeigt:

Fig. 1 eine aus zwei Schichten bestehende Thermosicherung

Fig. 2 die Thermosicherung nach deren Auslösen

Fig. 3 verschiedene Ausführungsformen der ersten Schicht

Fig. 4 ein Verbindungs- oder ein Sicherungselement mit einer Durchkontaktierung durch das Substrat

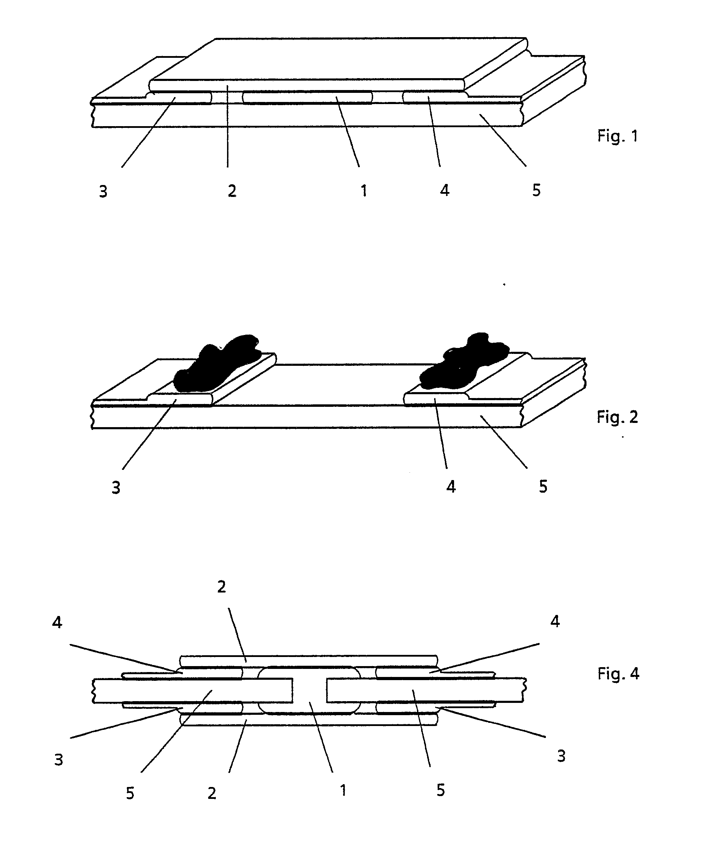

Die in Fig. 1 dargestellte Anordnung zeigt eine nach dem erfindungsgemässen Verfahren hergestellte Thermosicherung, welche im wesentlichen aus zwei übereinanderliegenden elektrisch leitenden Schichten 1,2 (z.B. Metallschichten) und zwei elektrisch leitenden Anschlüssen 3,4 besteht. Zwischen den zwei Anschlüssen 3,4 die sich auf einem Substrat 5 befinden, ist eine erste Metallschicht 1 auf das Substrat 5 aufgetragen, die die beiden Anschlüsse 3,4 in diesem Fall jedoch nicht verbindet. Vor dem Auftragen der zweiten Metallschicht 2 wirkt die Kontaktstelle, bestehend aus der Metallschicht 1 und den Anschlüssen 3,4 als elektrischer Unterbruch. Durch das Auftragen der Metallschicht 2 über die beiden Anschlüsse 3,4 und über die Metallschicht 1 wird eine elektrische Verbindung hergestellt. In diesem Beispiel ergibt sich durch das Auftragen der Metallschicht 2 eine elektrisch leitende Verbindung zwischen den Anschlüssen 3,4. Für die Schicht 1 könnte folglich auch ein nicht-oder nur teilweise leitendes Material verwendet werden. Durch geeignete Wahl des Materials für die erste und zweite Metallschicht erhält die beschriebene Verbindung spezielle Eigenschaften, die sie als Thermosicherung geeignet machen. Dabei wird vorausgesetzt, dass die Metallschicht 1 (bzw. 2), im Vergleich zu den Anschlüssen 3,4, gegenüber der Metallschicht 2 (bzw. 1) eine deutlich geringere Ablegierfestigkeit besitzt. Für die Metallschicht 1 kann z.B. Silber, Gold oder Kupfer und für die Metallschicht 2 ein Lot bestehend aus einer Indium-Zinn-,Indium-Blei, Wismut-Zinn- oder Zinn-Blei-Legierung verwendet werden. Durch die Verwendung von z.B. Hartloten oder Indium-Legierungen für die Metallschicht 2 können auch Thermosicherungen mit hohen bzw. tiefen Auslösetemperaturen hergestellt werden. Die Anschlüsse 3,4 bestehen z.B. aus einer Silber-Palladium-Legierung. Zusätzlich können die verwendeten Metalle und Legierungen noch weitere Elemente enthalten. Die Schicht 1 und/oder die Schicht 2 können selbst aus einer oder mehreren Schichten aufgebaut sein, die aus einem Metall, einer Legierung, einem Halbleiter oder aus einem oder mehreren weiteren Elementen bestehen. Dadurch können die Eigenschaften der hergestellten Thermosicherung weiter variiert werden.

Die Diffusionszone, die sich beim Auftragen der Metallschicht 2 zwischen den beiden Metallschichten 1,2 bildet, vergrössert sich bei steigender Temperatur weiter, bis die Metallschicht 1 von der Metallschicht 2 komplett absorbiert bzw. ablegiert wird. Eine vollständige Absorption tritt normalerweise auf, wenn die Metallschicht 2 in den flüssigen Zustand übergeht. Die Haftung zwischen der Metallschicht 1 und dem Substrat 5 ist dann aufgehoben. Die Metallschicht 2 wird daraufhin nicht mehr auf der Metallschicht 1 haften, sondern direkt auf dem Substrat 5 aufliegen. Im flüssigen Zustand wird sich die Metallschicht 2, nachdem sie die Metallschicht 1 komplett absorbiert hat, durch die Oberflächenspannung in zwei kugelförmige Teile aufgeteilt, welche sich in der Folge auf die beiden Anschlüsse 3,4 zurückziehen. Dieser Zustand ist in Fig. 2 dargestellt. Die Verbindung wird somit beim Überschreiten einer bestimmten Temperatur T aufgelöst.

Durch entsprechende Wahl der verwendeten Materialien sowie der aufgetragenen Dicken und Formen der beiden Metallschichten 1,2 können die Eigenschaften der Thermosicherung wunschgemäss verändert werden. Durch Auftragen einer dickeren oder dünneren ersten Metallschicht 1 kann die Auslösegeschwindigkeit bzw. die Trägheit der Thermosicherung verändert werden. Durch geeignete Auswahl des Materials für die beiden Metallschichten 1,2 kann sowohl die Trägheit wie auch die Auslösetemperatur der Thermosicherung variiert werden.

Der Anwender hat nun die Wahl, ob er einen Unterbruch (das Auftragen der zweiten Schicht wird unterlassen), eine Thermosicherung mit bestimmter Auslösegeschwindigkeit und Aus lösetemperatur oder lediglich eine Verbindung (Thermosicherung mit hoher Auslösetemperatur) zwischen den beiden Anschlüssen 3,4 erzeugen will.

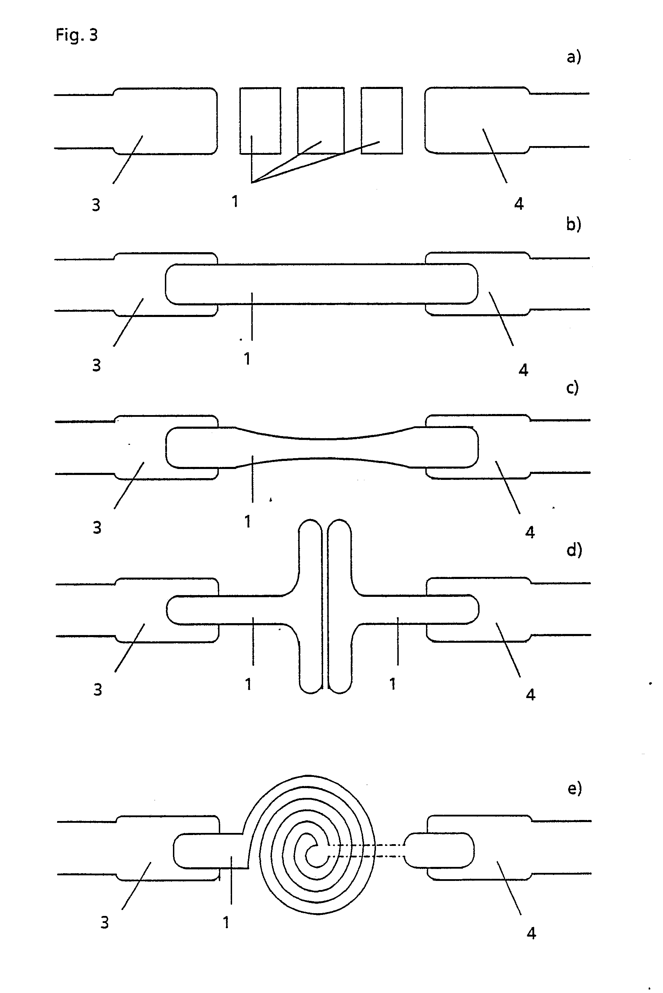

In Fig. 3 sind weitere Ausführungsformen der ersten Metallschicht 1 dargestellt. Fig. 3a zeigt den oben beschriebenen Fall mit einer teilweise unterbrochenen Metallschicht 1. Ohne das Auftragen der Metallschicht 2 entsteht keine Verbindung zwischen den Anschlüssen 3,4. In Fig. 3b und 3c hingegen verbindet die Metallschicht 1 die beiden Anschlüsse 3,4 miteinander. Eine elektrische Verbindung besteht hier also bereits vor dem Auftragen der Metallschicht 2. Durch das Auftragen der Metallschicht 2 kann nun eine Thermosicherung erzeugt werden. Da in Fig. 3c, bedingt durch die Ausführungsform der Metallschicht 1, dabei weniger Material aufgetragen wird als in Fig. 3b, ergibt sich für die entstehende Thermosicherung eine höhere Auslösegeschwindigkeit. Falls die Verbindung zwischen den beiden Anschlüssen 3,4 aufgehoben werden soll, um einen elektrischen Unterbruch zu erhalten, wird eine Thermosicherung mit so tiefer Auslösetemperatur erzeugt, dass sie bereits beim Auftragen der Metallschicht 2 (z.B. flüssiges Lot) auslöst. Falls notwendig, kann die Thermosicherung auch durch externe Wärmezufuhr (z.B. in einem Lötofen) ausgelöst werden. Der Hersteller kann also auch in diesem Falle wählen, ob er eine Verbindung (nur die erste Schicht auftragen), eine Thermosicherung oder einen Unterbruch (ausgelöste Thermosicherung) erzeugen will. Die in Fig. 3d und 3e gezeigten Ausführungsformen der Metallschicht 1 ermöglichen noch die Erzeugung einer Kapazität bzw. Induktivität (nur Metallschicht 1 ist aufgetragen) nebst den erwähnten Möglichkeiten zur Erzeugung einer Thermosicherung, einer Verbindung (Thermosicherung mit hoher Auslösetemperatur) oder einem Unterbruch (ausgelöste Thermosicherung). Weiterhin ist es in nicht gezeigter Weise auch möglich, die Metallschicht 1 in der Form eines Schachbrettmusters aufzutragen. Das Verhältnis der Grössen der belegten zu den unbelegten Feldern beeinflusst die sich ergebende Auslösegeschwindigkeit der Thermosicherung. Ferner ist es möglich die erste Metallschicht 1, welche die beiden Anschlüsse 3,4 miteinander verbindet, durch entsprechende Formgebung mit den Eigenschaften eines elektrischen Widerstandes herzustellen.

Die in Fig. 4 dargestellte Anordnung zeigt eine vorteilhafte Weiterbildung des erfindungsgemässen Verfahrens. Die Metallschicht 1 ist hier als Durchkontaktierung durch eine Öffnung des Substrats 5 angeordnet. Mittels der Metallschicht 2, die auf beiden Seiten des Substrats 5 je über die beiden Anschlüsse 3,4 und die Metallschicht 1 aufgetragen wird, wird eine Verbindung bzw. eine Thermosicherung hergestellt. Alle in Fig. 3 gezeigten Ausführungsformen der Metallschicht 1 können in analoger Weise auf das in Fig. 4 gezeigte Prinzip angewendet werden (Metallschicht 1 wird mit den Anschlüssen 3,4 verbunden oder nicht verbunden, oder in Spulen- bzw. Kondensatorform auf einer oder beiden Seiten der Durchkontaktierung angeordnet etc.). Falls eine gemäss Fig. 4 gefertigte Thermosicherung auslöst, wird die Metallschicht 1, die sich in der Substratöffnung befindet, durch das Ablegieren und die sich ergebende Oberflächenspannung abgesogen und die Substratöffnung wird freigelegt. Die in Fig. 4 gezeigte Anordnung kann somit auch als mechanischer Verschluss verwendet werden, der sich bei einer bestimmten Temperatur öffnet und z.B. ein Schutzgas austreten lässt. Die Metallschicht 1 muss dabei die Substratöffnung vor dem Auslösen der Thermosicherung zuverlässig verschliessen. Für diesen Anwendungsfall kann die Metallschicht 2 auch nur auf einer Seite des Substrats 5 aufgetragen werden, so z.B. falls keine elektrische Verbindung zwischen den Anschlüssen 3,4 benötigt wird.

Falls die beschriebene Thermosicherung bei unerlaubt hohen elektrischen Strömen auslösen soll, so kann noch ein Widerstand mit der Thermosicherung in Serie geschaltet und angeordnet werden, dass er wenigstens einen Teil seiner Verlustwärme an die Thermosicherung abgibt, und so zum Auslösen der Thermosicherung beiträgt.

Zur erfindungsgemässen Herstellung der Thermosicherungen und Verbindungen oder zur Erzeugung von Unterbrüchen ist es speziell von Vorteil, die Metallschicht 1 mit einem Siebdruckverfahren auf das Substrat 5 aufzubringen und die Metallschicht 2 im Reflow- oder Schwalllötverfahren auf die Anschlüsse 3,4 und die Metallschicht 1 aufzutragen. Dadurch wird es in einfacher Weise möglich, eine Vielzahl der Verbindungs- und Sicherungs- Elemente bzw. Unterbrüche gleichzeitig auf ein Substrat aufzubringen. Zur Erzeugung der Metallschichten 1 und 2 können aber auch Verfahren, welche in der Dünnschicht- oder Leiterplattentechnik üblich sind, wie z.B. galvanisches oder chemisches Abscheiden, eingesetzt werden.

## Ansprüche

1. Verfahren zum wahlweisen Herstellen von Thermosicherungen, elektrischen Verbindungen oder zum Erzeugen von Unterbrüchen, dadurch gekennzeichnet, dass zwischen zwei auf einem Substrat (5) aufgebrachten Anschlüssen (3,4) eine durchgehende oder eine unterbrochene Schicht (1) aufgetragen und dass anschliessend die Anschlüsse (3,4) und die Schicht (1) mit einer durchgehenden Schicht (2) überzogen werden, wobei die Materialien für die Schichten (1,2) sowie deren geometrische Auslegung so gewählt sind, dass die Schicht (1) bzw. (2) nach Erwärmung der beiden Schichten (1,2) auf eine bestimmte Temperatur T von der Schicht (2) bzw. (1) ablegiert und vom Substrat (5) abgelöst wird, wobei die verbleibende Schicht nachfolgend im flüssigen Zustand die Verbindung zwischen den beiden Anschlüssen (3,4) auflöst.

2. Verfahren nach Anspruch 1, dadurch gekennzeichnet, dass die Schicht (1) und oder die Schicht (2) aus elektrisch leitenden Materialien besteht.

3. Verfahren nach Anspruch 2, dadurch gekennzeichnet, dass die Temperatur T einer maximal zulässigen Temperatur des Substrats (5) entspricht, nach deren Überschreiten die Verbindung aufgelöst wird.

4. Verfahren nach Anspruch 1, dadurch gekennzeichnet, dass nur die Schicht (1) einfach oder mehrfach unterbrochen aufgetragen wird.

5. Verfahren nach Anspruch 3, dadurch gekennzeichnet, dass die Temperatur T bereits beim Auftragen der Schicht (2) erreicht wird.

6. Verfahren nach Anspruch 5, dadurch gekennzeichnet, dass die Temperatur T erst durch externe Wärmezufuhr überschritten wird.

7. Verfahren nach Anspruch 3, dadurch gekennzeichnet, dass die zwischen den Anschlüssen (3,4) erzeugte elektrische Verbindung mit einem Widerstand in Serie geschaltet wird, der so angeordnet ist, dass er wenigstens einen Teil seiner Verlustwärme an die Verbindung abgibt.

8. Verfahren nach Anspruch 1, dadurch gekennzeichnet, dass auf das Substrat (5) eine oder mehrere Thermosicherungen aufgebracht werden, die nicht Bestandteil der elektrischen Schaltung sind und deren Schichten (1,2) derart gewählt sind, dass das Auslösen einer Thermosicherung das Überschreiten einer festgelegten Temperatur des Substrats (5) anzeigt.

9. Verfahren nach einem der vorhergehenden Ansprüche, dadurch gekennzeichnet, dass die Schicht (1) durchgehend durch eine Öffnung im Substrat (5) aufgetragen wird.

10. Verfahren nach Anspruch 9, dadurch gekennzeichnet, dass der Anschluss (3) auf der einen Seite und der Anschluss (4) auf der anderen Seite des Substrats (5) aufgetragen wird.

11. Verfahren nach Anspruch 10, dadurch gekennzeichnet, dass auf einer oder beiden Seiten des Substrats (5) die Schicht (1) und der zugehörige Anschluss mit der Schicht (2) überzogen wird.

12. Verfahren nach Anspruch 11, dadurch gekennzeichnet, dass die Schicht (1) so aufgetragen wird, dass sie die Öffnung auf mindestens einer Seite des Substrats (5) dicht abschliesst und erst nach dem Auslösen der Thermosicherung wieder freigibt.

13. Verfahren nach einem der vorhergehenden Ansprüche, dadurch gekennzeichnet, dass die Schicht (1) in der Form eines Widerstandes, eines Kondensators oder einer Spule auf das Substrat (5) aufgetragen wird.

14. Verfahren nach einem der vorhergehenden Ansprüche, dadurch gekennzeichnet, dass die Schicht (1) im Siebdruckverfahren aufgebracht wird.

15. Verfahren nach einem der vorhergehenden Ansprüche, dadurch gekennzeichnet, dass die Schicht (2) mit einem bekannten, z.B. dem Reflow- oder Schwall- Lötverfahren, auf die Schicht (1) und die beiden Anschlüsse (3,4) aufgetragen wird.

16. Verfahren nach einem der vorhergehenden Ansprüche, dadurch gekennzeichnet, dass für die Schichten (1,2) Materialien verwendet werden, die zusammen ein Eutektikum bilden können.

17. Verfahren nach einem der vorhergehenden Ansprüche, dadurch gekennzeichnet, dass die Schicht (1) aus Silber, Gold oder Kupfer besteht, und / oder dass die Schicht (2) aus einem Weichlot wie einer Zinn-Blei-, Indium-Blei-, Indium-Zinn- oder einer Wismut-Zinn- Legierung oder aus einem Hartlot besteht, und / oder dass die Anschlüsse (3,4) aus einer Silber-Palladium- Legierung bestehen und dass alle Schichten bzw. Anschlüsse noch weitere Materialien enthalten können.

18. Verfahren nach einem der vorhergehenden Ansprüche, dadurch gekennzeichnet, dass die Schicht (1) und / oder die Schicht (2) aus einer oder mehreren Schichten bestehen.

19. Verfahren nach Anspruch 18, dadurch gekennzeichnet, dass die aufgetragenen Schichten je aus einem Metall, einer Legierung, einem Halbleiter oder einem oder mehreren weiteren Materialien bestehen.

20. Anwendung des Verfahrens nach Anspruch 12 für eine Thermosicherung, die als Verschluss für einen Behälter für Gase, Flüssigkeiten oder Feststoffe dient, die nach dem Auslösen der Thermosicherung durch das Öffnen des Verschlusses freigegeben werden bzw. heraustreten können.

88P9811

Fig. 1

3          2          1          4          5

Fig. 2

3                    4          5

Fig. 4

2

4          4

3          3

5     2          1     5

88P9811

Fig. 3

a)

3        1                                        4

b)

3        1                                        4

c)

3        1                                        4

d)

3        1            1                           4

e)

3        1                                        4